# EUROPEAN PATENT APPLICATION

(11) **EP 4 760 291 A1**
(43) Date of publication of application: **17.06.2026**
(21) Application number: 25196282.5
(22) Date of filing: 15.08.2025
(51) Int. Cl.: G01R 31/367, G01R 31/3835, G01R 31/385, G01R 31/396, G06F 17/18, H01M 10/48

(54) **APPARATUS AND METHOD FOR DIAGNOSING BATTERY, AND COMPUTER PROGRAM**

(30) Priority: 16.12.2024 KR 20240187275
(71) Applicant: SAMSUNG SDI CO., LTD., Yongin-si, Gyeonggi-do 17084 (KR)
(72) Inventor: KIM, Ji Han, 16678 Suwon-si (KR); HWANG, Sun Uk, 16678 Suwon-si (KR)
(74) Representative: Marks & Clerk LLP

(57) **Abstract**

An apparatus for diagnosing a plurality of battery cells based on diagnostic data acquired from the plurality of battery cells includes a processor configured to diagnose the plurality of battery cells; and a memory configured to store instructions that are executed by the processor, wherein, based on the instructions, the processor is configured to: acquire a raw diagnostic dataset of the plurality of battery cells; generate a smoothed diagnostic dataset by smoothing noise in the raw diagnostic dataset due to a deviation in positions at which the plurality of battery cells are left unattended; generate a normalized diagnostic dataset by normalizing the raw diagnostic dataset based on the smoothed diagnostic dataset; and diagnose the plurality of battery cells based on the normalized diagnostic dataset.

## Description

### BACKGROUND

### 1. Field

Aspects of the present disclosure relate to an apparatus and method for diagnosing a battery.

### 2. Description of the Related Art

As the demand for portable electronic products such as notebooks, video cameras, and portable phones is rapidly increasing and the commercialization of robots, electric vehicles, etc., is in full swing, research on high-performance secondary batteries capable of being repeated charged and discharged is actively being conducted.

Battery cells of secondary batteries can be manufactured by placing an electrode assembly inside a battery case, adding an electrolyte, and sealing the battery case. The battery cells manufactured in this way can be shipped after being activated through a formation process in which charging and discharging are performed on a trial basis.

When metal foreign substances are introduced into battery cells during a manufacturing process of secondary batteries, a short circuit state in which positive and negative electrodes of the battery cells are in electrical contact with each other is caused by ionization growth of the metal foreign substances, and thus a current flows inside the battery cell. When an overcurrent flows due to a short circuit, a separation film in the battery cell may be damaged or thermal runaway may occur. To prevent damage to the separation film and thermal runaway in the battery cell, a safety evaluation is performed to detect a low voltage in the battery cell during the formation process and detect an abnormal battery cell.

The above information disclosed in this Background section is for enhancement of understanding of the background of the present disclosure, and therefore, it may contain information that does not constitute related (or prior) art.

### SUMMARY

Aspects of some embodiments of the present disclosure are directed to providing an apparatus and method for diagnosing a battery and a computer program that are capable of more accurately detecting an abnormal battery cell having a low voltage in a formation process.

However, objects that the present disclosure intends to achieve are not limited to the above-described objects and other objects that are not described may be clearly understood by those skilled in the art from the following description.

According to some embodiments of the present disclosure, there is provided an apparatus for diagnosing a plurality of battery cells based on diagnostic data acquired from the plurality of battery cells, the apparatus including: a processor configured to diagnose the plurality of battery cells; and a memory configured to store instructions that are executed by the processor, wherein, based on the instructions, the processor is configured to: acquire a raw diagnostic dataset of the plurality of battery cells; generate a smoothed diagnostic dataset by smoothing noise in the raw diagnostic dataset due to a deviation in positions at which the plurality of battery cells are left unattended; generate a normalized diagnostic dataset by normalizing the raw diagnostic dataset based on the smoothed diagnostic dataset; and diagnose the plurality of battery cells based on the normalized diagnostic dataset.

In some embodiments, the processor is configured to acquire the raw diagnostic dataset by arranging the raw diagnostic data of each of the plurality of battery cells based on continuity of the positions at which the plurality of battery cells are left unattended.

In some embodiments, the processor is configured to generate the smoothed diagnostic dataset by applying a window having a set size to the raw diagnostic dataset and determining a representative value of a plurality of pieces of raw diagnostic data within the window.

In some embodiments, the processor is configured to generate the smoothed diagnostic dataset by sliding the window stepwise from first raw diagnostic data to last raw diagnostic data of the raw diagnostic dataset and sequentially arranging representative values determined at each sliding operation.

In some embodiments, the representative value is a median value.

In some embodiments, the processor is configured to generate the normalized diagnostic dataset as a difference between the raw diagnostic dataset and the smoothed diagnostic dataset.

In some embodiments, the processor is configured to diagnose the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality of pieces of normalized diagnostic data with the determined reference value.

In some embodiments, the diagnostic data is a cell voltage change amount or an open circuit voltage change amount of each of the plurality of battery cells formed after the plurality of battery cells are left unattended for a reference time in a formation process of the plurality of battery cells.

In some embodiments, the plurality of battery cells are loaded on a tray in a form of a matrix and left unattended for the reference time to acquire the diagnostic data in the formation process.

According to some embodiments of the present disclosure, there is provided a method of diagnosing a plurality of battery cells based on diagnostic data acquired from the plurality of battery cells, the method including: acquiring, by a processor, a raw diagnostic dataset of the plurality of battery cells; generating, by the processor, a smoothed diagnostic dataset by smoothing noise reflected in the raw diagnostic dataset due to a deviation in positions at which the plurality of battery cells are left unattended; generating, by the processor, a normalized diagnostic dataset by normalizing the raw diagnostic dataset based on the smoothed diagnostic dataset; and diagnosing, by the processor, the plurality of battery cells based on the normalized diagnostic dataset.

In some embodiments, in the acquiring of the raw diagnostic dataset, the processor acquires the raw diagnostic dataset by arranging the raw diagnostic data of each of the plurality of battery cells based on continuity of the positions at which the plurality of battery cells are left unattended.

In some embodiments, in the generating of the smoothed diagnostic dataset, the processor generates the smoothed diagnostic dataset by applying a window having a set size to the raw diagnostic dataset and determining a representative value of a plurality of pieces of raw diagnostic data included in the window.

In some embodiments, in the generating of the smoothed diagnostic dataset, the processor generates the smoothed diagnostic dataset by sliding the window stepwise from first raw diagnostic data to last raw diagnostic data of the raw diagnostic dataset and sequentially arranging representative values determined at each sliding operation.

In some embodiments, in the generating of the normalized diagnostic dataset, the processor generates the normalized diagnostic dataset as a difference between the raw diagnostic dataset and the smoothed diagnostic dataset.

In some embodiments, in the diagnosing of the plurality of battery cells, the processor diagnoses the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality of pieces of normalized diagnostic data with the determined reference value.

According to some embodiments of the present disclosure, there is provided a computer program stored in a computer-readable storage medium for performing, in combination with hardware, a battery diagnostic method of diagnosing a plurality of battery cells based on diagnostic data acquired from the plurality of battery cells, wherein the battery diagnostic method includes: acquiring a raw diagnostic dataset of the plurality of battery cells; generating a smoothed diagnostic dataset by smoothing noise reflected in the raw diagnostic dataset due to a deviation in positions at which the plurality of battery cells are left unattended; generating a normalized diagnostic dataset by normalizing the raw diagnostic dataset based on the smoothed diagnostic dataset; and diagnosing the plurality of battery cells based on the normalized diagnostic dataset.

At least some of the above features of the invention and others are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram illustrating an apparatus for diagnosing a battery according to some embodiments of the present disclosure;
FIG. 2 is an example diagram illustrating how a plurality of battery cells are loaded on a tray in the form of a matrix according to some embodiments of the present disclosure;
FIG. 3 is an example diagram illustrating a raw diagnostic dataset according to some embodiments of the present disclosure;
FIGS. 4A and 4B are example diagrams illustrating a method of constructing a raw diagnostic dataset according to some embodiments of the present disclosure;
FIG. 5 is an example diagram for describing an operation of a processor and a process of acquiring a smoothed diagnostic dataset according to some embodiments of the present disclosure;
FIGS. 6 and 7 are example diagrams illustrating battery diagnostic results according to some embodiments of the present disclosure; and
FIG. 8 is a flowchart illustrating a method of diagnosing a battery according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be provided in singular or plural form.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

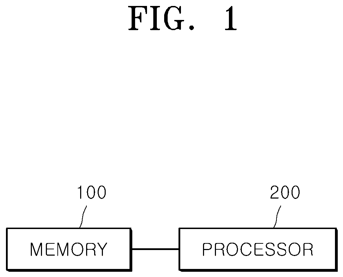

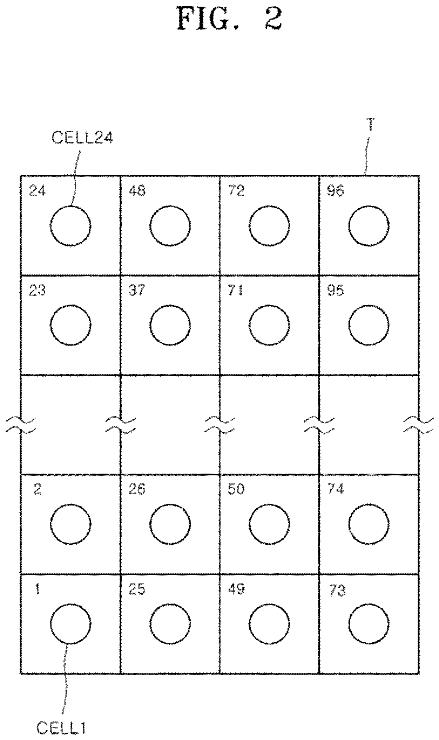

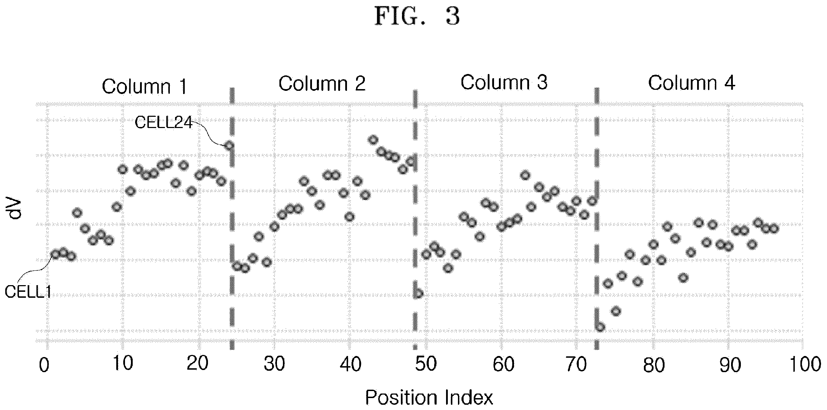

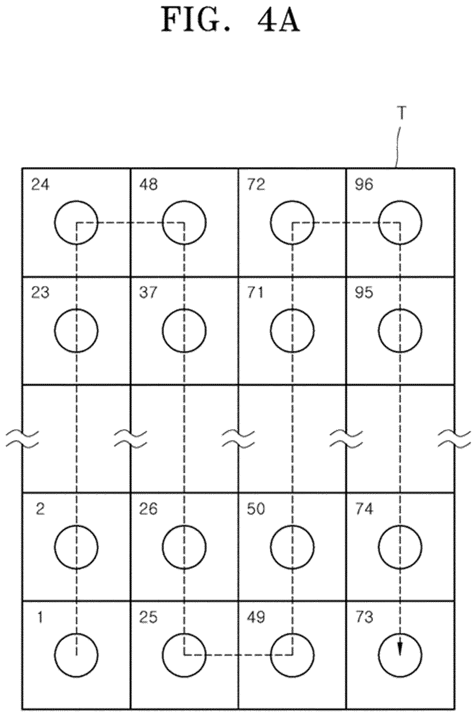

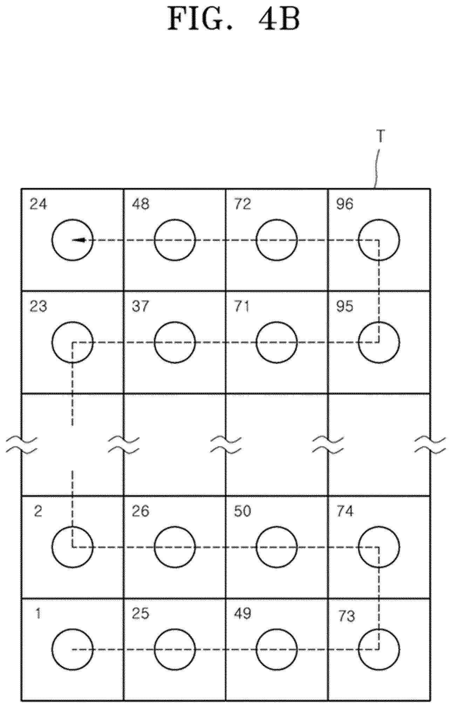

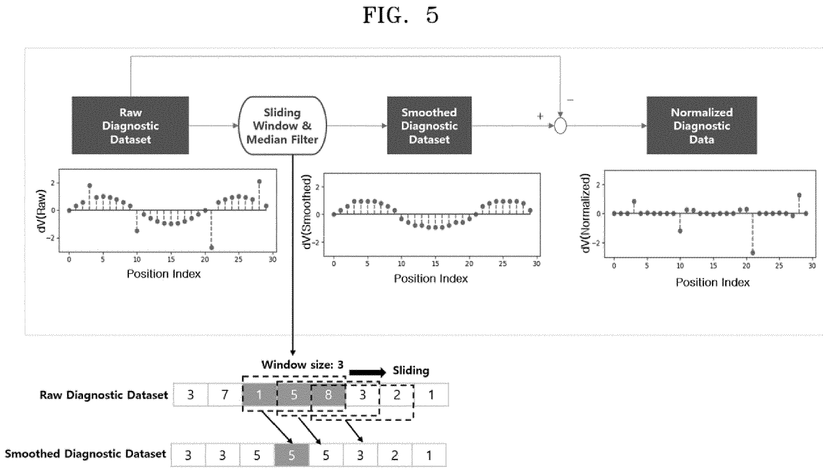

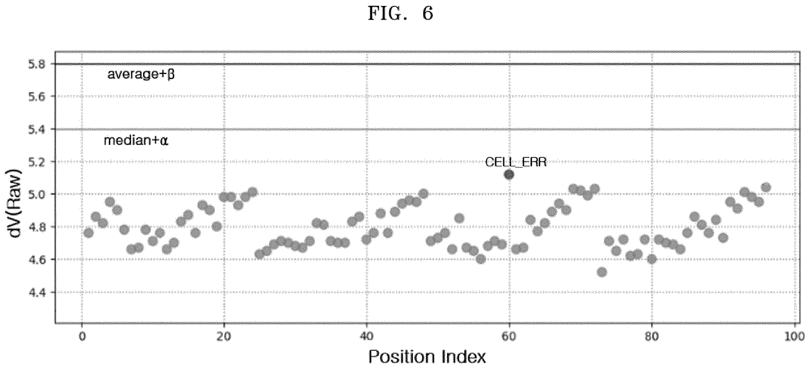

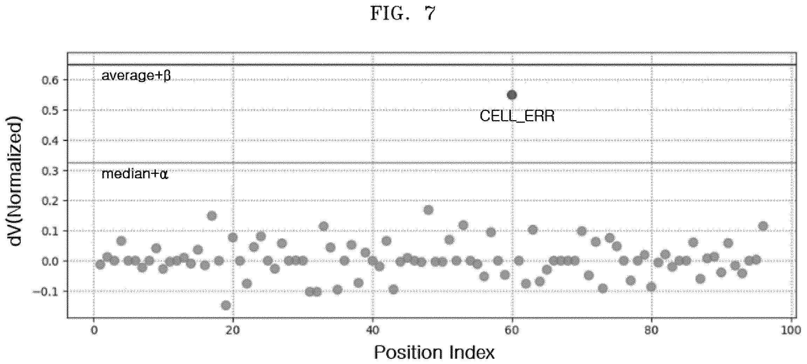

FIG. 1 is a block diagram illustrating an apparatus for diagnosing a battery according to some embodiments of the present disclosure, FIG. 2 is an example diagram illustrating how a plurality of battery cells are loaded on a tray in the form of a matrix according to some embodiments of the present disclosure, FIG. 3 is an example diagram of a raw diagnostic dataset according to some embodiments of the present disclosure, FIGS. 4A and 4B are example diagrams illustrating a method of constructing a raw diagnostic dataset according to some embodiments of the present disclosure, FIG. 5 is an example diagram for describing an operation of a processor and a process of acquiring a smoothed diagnostic dataset according to some embodiments of the present disclosure, and FIGS. 6 and FIG. 7 are example diagrams illustrating battery diagnostic results according to some embodiments of the present disclosure.

Referring to FIG. 1, the apparatus for diagnosing a battery according to some embodiments may include a memory 100 and a processor 200.

At least one instruction that is executed in a process of diagnosing a plurality of battery cells by the processor 200 to be described below may be stored in the memory 100. The memory 100 may store basic data utilized for diagnosing the plurality of battery cells or may store data generated in the process of diagnosing the plurality of battery cells by the processor 200, and the processor 200 may access the data stored in the memory 100 and perform a diagnostic operation on the plurality of battery cells. The memory 100 may be implemented as a computer-readable recording medium and operated so that the processor 200 accesses the memory 100. For example, the memory 100 may be implemented as a hard drive, a magnetic tape, a memory card, a read-only memory (ROM), a random-access memory (RAM), or an optical data storage device such as a digital video disc (DVD) or an optical disc.

The processor 200 performs the diagnostic operation on the plurality of battery cells. The processor 200 may be implemented as an application specific integrated circuit (ASIC), a digital signal processor (DSP), programmable logic devices (PLDs), field programmable gate arrays (FPGAs), a central processing unit (CPU), microcontrollers, and/or microprocessors. The processor 200 may run an operating system or an application and control a plurality of hardware or software components. The processor 200 may be configured to execute at least one instruction stored in the memory 100 and store the execution result data in the memory 100. The processor 200 may correspond to an integrated controller that controls a charging/discharging process, an aging process, a degassing process, and/or a test process for selecting good products performed in a formation process during a battery manufacturing process. Among the processes that constitute the formation process described above, the battery cell diagnostic operation may be applied to the test process.

In some embodiments, the process of diagnosing the plurality of battery cells may be broadly divided into the operations of i) acquiring a raw diagnostic dataset, ii) generating a smoothed diagnostic dataset, iii) generating a normalized diagnostic dataset, and iv) finally diagnosing the plurality of battery cells based on the normalized diagnostic dataset.

Terms are clearly defined to aid understanding of the embodiment. The raw diagnostic dataset is a set of a plurality of raw diagnostic data, the smoothed diagnostic dataset is a set of a plurality of smoothed diagnostic data, and the normalized diagnostic dataset is a set of a plurality of normalized diagnostic data. The raw diagnostic dataset, smoothed diagnostic dataset, and normalized diagnostic dataset, which are constructed with a plurality of data, may each have a one-dimensional or two-dimensional data form (to aid the understanding the embodiments, each dataset is described below as having a one-dimensional data form).

The diagnostic data may correspond to voltage data that refer to a cell voltage change amount (dV) or an open circuit voltage change amount (ΔOCV) of a battery cell. That is, the diagnostic data may be the cell voltage change amount or open circuit voltage change amount formed during the process of leaving each battery cell for a long period of time (i.e. predefined reference time) after the charging/discharging process is performed on each battery cell in the formation process (to aid the understanding the embodiments, the diagnostic data is described below as the cell voltage change amount). The cell voltage may be the electrical potential difference measured across the terminals of a battery cell when a current is flowing between the terminals. Conversely, the open circuit voltage may be the electrical potential difference measured across the terminals of a battery cell when no current is flowing between the terminals.

Based on the above description, the operation of the processor 200 will be described in further detail below.

In the formation process, after the charging/discharging process for the plurality of battery cells is completed, the plurality of battery cells may be left unattended for a set or predefined reference time after being loaded on the tray (T). The reference time described above is a time period for measuring the cell voltage change amount (i.e., the raw diagnostic data) of the battery cells and may be predefined as a specific value according to the specifications of the battery cells to be manufactured and the intention of the designer. For example, the processor (200) may determine the start and end of a reference time through a separately provided timer, which can be operated by a user's manipulation. Accordingly, the processor (200) may recognize the time period from when the timer is turned on by the user to when it is turned off as the reference time, and determine that the battery cells remains in a unattended state during the recognized reference time.

Referring to FIG. 2, a tray T on which a plurality of battery cells are loaded may be in the form of a matrix. Each of the plurality of battery cells may be loaded on one of a plurality of grids defined on the tray T by the matrix form, and each grid may be provided with a slot for loading a battery cell. FIG. 2 illustrates an example of a tray T having a "4x24" matrix form (although other arrangements are possible). The battery cell loaded on each grid on the tray T may be left unattended in a separately prepared formation room for the reference time described above. A difference between a voltage (e.g. a cell voltage or an open circuit voltage) of the battery cell measured at the time when the battery cell is loaded on the grid of the tray T and a voltage of the battery cell measured at the time when the reference time has elapsed (i.e., a cell voltage change amount or open circuit voltage change amount) may be raw diagnostic data of the corresponding battery cell. The processor 200 may acquire the raw diagnostic data by measuring a cell voltage (or open circuit voltage) of the battery cell for the reference time and calculating a change amount thereof, and a connection and wiring structure may be provided for the processor 200 to measure the cell voltage (or open circuit voltage) of the battery cell loaded on the tray T and left unattended. In addition, the connection and wiring structure described above may support a function of providing a position index indicating a grid position of the tray T on which the battery cell is loaded, and the processor 200 may manage the raw diagnostic data together with the position index corresponding thereto. When the raw diagnostic data of all the battery cells loaded on the tray T is acquired, the processor 200 may perform construction of a raw diagnostic dataset as a group of acquired raw diagnostic data of each battery cell. FIG. 3 illustrates an example of the raw diagnostic dataset (see, e.g., FIG. 3, where the horizontal axis is the position index described above and the vertical axis is the cell voltage change amount).

As described above, the raw diagnostic data of the battery cell is acquired when the battery cell is loaded on the tray T and left unattended in the formation room. When environmental conditions such as temperature and humidity within the formation room are not well controlled, a deviation in the environmental conditions may occur depending on a position within the formation room, and considering that the temperature and humidity are factors that affect the cell voltage of the battery cell, the environmental deviation in the formation room becomes a cause of reduction in the accuracy of the raw diagnostic data. For example, in the example of FIG. 2, even when a first battery cell CELL1 and a twenty-fourth battery cell CELL24 actually have the same voltage characteristics, when there is a deviation between the environmental conditions at the position of the first battery cell CELL1 and the environmental conditions at the position of the twenty-fourth battery cell CELL24, a deviation between the cell voltage change amount of the first battery cell CELL1 and the cell voltage change amount of the twenty-fourth battery cell CELL24 may occur. Referring to FIG. 3, it can be confirmed that there is a large deviation between the cell voltage change amounts of the first to twenty-fourth battery cells loaded on a first column (Column 1) of the tray T, and it can be confirmed that this trend similarly appears for second to fourth columns (Column 2 to Column 4). The greater the deviation between the cell voltage change amounts, the more the accuracy of the raw diagnostic data decreases, which may cause a situation in which a normal battery cell is erroneously detected as an abnormal battery cell or an abnormal battery cell is erroneously detected as a normal battery cell.

To solve the above-described problem, the processor 200 may perform the diagnostic operation on a plurality of battery cells based on a normalized diagnostic dataset obtained by normalizing the raw diagnostic dataset, rather than the raw diagnostic dataset.

For example, first, the processor 200 may acquire the raw diagnostic dataset by arranging raw diagnostic data of each of the plurality of battery cells acquired through the process described above based on the continuity of the positions where the plurality of battery cells are left unattended. The continuity of the positions where the plurality of battery cells are left unattended may be the continuity of the positions where the plurality of battery cells are loaded on the tray T. For instance, the continuity of the positions where the plurality of battery cells are left unattended may be the relative locations where the plurality of battery cells are loaded within the battery. The continuity of the positions may be indicated by position indices allocated to the battery cells based on relative position. The processor 200 may construct the raw diagnostic dataset by consecutively arranging the raw diagnostic data of the battery cells that are consecutively loaded on the tray T.

FIG. 4A illustrates an example of how a raw diagnostic dataset is constructed. When raw diagnostic data of each of first to N^{th} battery cells are denoted as first to N^{th} raw diagnostic data (D_RAW1 to D_RAWN), according to the example of FIG. 4A, the raw diagnostic dataset may be constructed in the form of [D_RAW1, D_RAW2....D_RAW24, D_RAW48, D_RAW47....D_RAW25, D_RAW49, D_RAW50....D_RAW72, D_RAW96, D_RAW95....D_RAW73]. As shown in FIG. 4A, the position index may increase from a bottom row to a top row, and may increase from a left column to a right column. For instance, the position index may start in the bottom left cell, and increase to a top left cell. The position index may then increase from the bottom of the next column to the top of the next column. The raw diagnostic data may be constructed through a vertical zig-zag pattern, where the position index increases up one column, before descending down the next column. The columns may be traversed sequentially, alternating the direction of selection within each column: bottom-to-top for the first, top-to-bottom for the second, and so forth.

FIG. 4B illustrates another example of how the raw diagnostic dataset is constructed. According to FIG. 4B, the raw diagnostic dataset may be constructed in the form of [D_RAW1, D_RAW25, D_RAW49, D_RAW73, D_RAW74, D_RAW50, D_RAW26, D_RAW2, D_RAW3.......D_RAW96, D_RAW72, D_RAW48, D_RAW24]. In this case, the zig-zag pattern is formed horizontally. Rows are traversed sequentially, alternating direction of selection within each row.

According to the construction method of the raw diagnostic dataset as described above, raw diagnostic data adjacent to each other in the constructed raw diagnostic dataset correspond to the raw diagnostic data of the battery cells existing in positions adjacent to each other on the tray T, and the plurality of raw diagnostic data aligned based on such positional continuity may serve as a prerequisite construction to ensure the validity of a representative value determination operation according to a sliding window (or moving window) method to be described below.

While particular examples of data construction are shown, it will be appreciated that other potential orders of selection are possible. In general, it is advantageous if the order of selection ensures that each successively selected cell is adjacent to the previously selected cell. This ensures positional continuity, so that relative position is encoded through the order of selection. Furthermore, while a particular example of position index labelling is described herein, it will be appreciated that the cell positions may be labelled through alternative labelling methods and/or alternative orders (e.g. left to right, top to bottom, etc.).

When the raw diagnostic dataset is acquired, the processor 200 may generate a smoothed diagnostic dataset by smoothing out noise reflected in the raw diagnostic dataset due to a deviation in the positions where a plurality of battery cells are left unattended (i.e., a deviation between the positions where the plurality of battery cells are loaded on the tray T). The smoothing may remove or reduce the noise within the smoothed diagnostic dataset. As described above, the deviation between the positions where the plurality of battery cells are loaded on the tray T may be representative of the deviation between the environmental conditions at the corresponding positions, and therefore the noise described above may be the noise reflected in the raw diagnostic data according to the environmental deviation at the positions where the plurality of battery cells are loaded on the tray T.

The processor 200 may generate the smoothed diagnostic dataset by applying a window having a set or predefined size to the raw diagnostic dataset and determining a representative value of a plurality of pieces of raw diagnostic data included in the window. For example, the processor 200 may generate the smoothed diagnostic dataset by sliding the window stepwise from first raw diagnostic data to last raw diagnostic data of the raw diagnostic dataset, and sequentially arranging the representative values determined at each sliding operation. The representative value described above may be a median value (e.g., a median value of the values within the window).

FIG. 5 illustrates an example of a process of acquiring a smoothed diagnostic dataset. In the example of FIG. 5, a size of the window is set or predefined as 3, and it should be noted that the specific numerical value of each data is intended to be merely an example to aid in understanding of some of the embodiments; however, embodiments of the present disclosure are not limited thereto. For instance, various window sizes may be applied. The window selects a predefined number of consecutive raw diagnostic data entries from the raw diagnostic data. As the window progresses (e.g. slides), one or more new entries are added, and one or more old entries are removed from the window. The window may be progressed (e.g. may slide) by a step size. The step size may be one, or may be a value greater than or equal to one. The step size may be greater than or equal to one and less than the window size.

When raw diagnostic data included in the current window correspond to values of 1, 5, and 8, the median value of 5 is determined as smoothed diagnostic data. As the window slides, when the raw diagnostic data included in the next window correspond to 5, 8, and 3, the median value of 5 is determined as the smoothed diagnostic data. As the window slides, when the raw diagnostic data included in the next window correspond to 8, 3, and 2, the median value of 3 is determined as the smoothed diagnostic data. The processor 200 may generate the smoothed diagnostic dataset by sequentially arranging the smoothed diagnostic data of 5, 5, and 3 determined as described above (in the sliding direction of the window). A median filter may be used as a filter for determining the median value (FIG. 5 illustrates an example in which a one-dimensional median filter is used because a dataset is constructed as a one-dimensional data form, but a two-dimensional median filter may be used when the dataset is constructed as a two-dimensional data form).

Through the smoothing process using the sliding window and median filter as described above, the noise due to environmental deviation reflected in the raw diagnostic dataset may be smoothed and a smoothed diagnostic dataset may be generated.

When the smoothed diagnostic dataset is generated, the processor 200 may generate a normalized diagnostic dataset by normalizing the raw diagnostic dataset through the smoothed diagnostic dataset. In some examples, as illustrated in FIG. 5, the processor 200 may generate a normalized diagnostic dataset as a difference between the raw diagnostic dataset and the smoothed diagnostic dataset. Because the normalized diagnostic dataset generated as above corresponds to normalized data in which the noise due to environmental deviation reflected in the raw diagnostic dataset has been removed, the normalized diagnostic dataset may serve as highly reliable diagnostic data applicable to detecting an abnormality in a battery cell (i.e., a low voltage defect).

The processor 200 may diagnose a plurality of battery cells based on the normalized diagnostic dataset. A statistical technique may be employed as a diagnostic method of the plurality of battery cells.

For example, the processor 200 may diagnose the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality of pieces of normalized diagnostic data and the reference value.

For example, the processor 200 may determine a median and an average value as representative values of the plurality of normalized diagnostic data included in the normalized diagnostic dataset, and determine the reference values as "median + α" and "average + β." α and β may be respective threshold offsets. α and β may be set or predefined according to the specifications and model of the battery cell. α and β may be determined relative to the median and average values (e.g. percentages of the median and average values respectively). The processor 200 may determine the battery cell as an abnormal battery cell (i.e., a battery cell having a low voltage defect) when a value of the normalized diagnostic data exceeds both the reference values of "median + α" and "average + β." Additionally, some embodiments in which the battery cell is additionally left unattended and is subjected to re-test (re-diagnosis) on the battery cell may be provided when the representative value of the normalized diagnostic data is greater than a threshold "γ" and less than or equal to "average + β" even when the value of the normalized diagnostic data is less than or equal to "median + α" or less than or equal to "average + β." For instance, a re-test may be implemented after a further predefined period of time (e.g. since the preceding diagnostic test). The further predefined period of time may be the same as reference time. The re-test may implemented after the further predefined period of time when the representative value of the normalized diagnostic data is greater than a threshold "γ" and less than or equal to "average + β" even when the value of the normalized diagnostic data is less than or equal to "median + α" or less than or equal to "average + β."

FIG. 6 illustrates the results of diagnosing a battery based on a raw diagnostic dataset according to some embodiments of the present disclosure, and FIG. 7 illustrates the results of diagnosing a battery based on a normalized diagnostic dataset generated according to some embodiments of the present disclosure.

Referring to FIG. 6, it can be confirmed that the raw diagnostic dataset reflects noise due to the deviations in environmental conditions depending on the position in the formation room, and therefore it can be confirmed that the dispersion among a plurality of pieces of raw diagnostic data constructing the raw diagnostic dataset is large. Assuming that a battery cell diagnostic method using the statistical technique described above, that is, the reference values "median + α" and "average value + β," is applied, large dispersion among the plurality of pieces of raw diagnostic data causes an increase in the median and average value that determine the reference value, and accordingly, the reference value increases as much as the influence of the noise due to the environmental deviation. Accordingly, in such a battery cell diagnostic method using the statistical technique described above, as illustrated in FIG. 6, there is a limitation that, due to having large raw diagnostic data (i.e., large cell voltage change amount), a battery cell (CELL_ERR) that should be determined as an abnormal battery cell is determined to have raw diagnostic data less than or equal to a reference value and thus is erroneously determined as a normal battery cell.

Referring to FIG. 7, since the normalized diagnostic dataset corresponds to normalized data from which the noise due to the environmental deviation reflected in the raw diagnostic dataset is removed, the influence of the noise due to the environmental deviation can be removed when determining the reference value that serves as the diagnosis reference for the battery cell, and therefore the reliability of the reference value is secured, and the corresponding normalized diagnostic data of the abnormal battery cell may be detected as a clear outlier for the reference value, so that the detection accuracy of the abnormal battery cell can be improved.

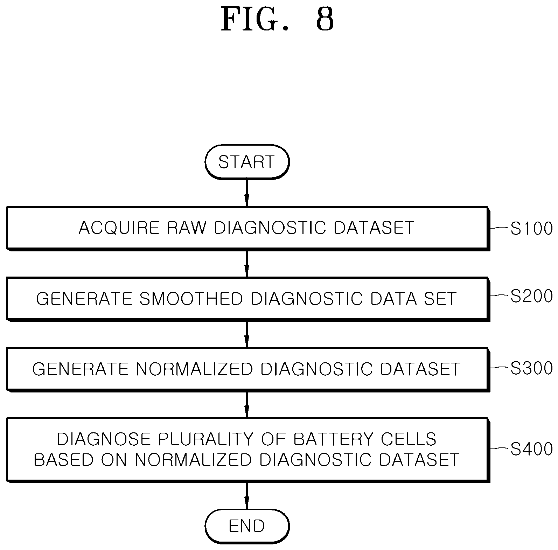

FIG. 8 is a flowchart illustrating a method of diagnosing a battery according to some embodiments of the present disclosure. The method of diagnosing the battery according to some embodiments will be described with reference to FIG. 8, omitting detailed description of a portion overlapping the content described above and mainly describing a time-series configuration thereof.

First, the processor 200 acquires a raw diagnostic dataset of a plurality of battery cells (S100). In some embodiments, the processor 200 acquires a raw diagnostic dataset by arranging the raw diagnostic data of each of the plurality of battery cells based on the continuity of the positions where the plurality of battery cells are left unattended.

Subsequently, the processor 200 generates a smoothed diagnostic dataset by smoothing noise reflected in the raw diagnostic dataset due to a deviation in positions where the plurality of battery cells are left unattended (S200). In some embodiments, the processor 200 may generate the smoothed diagnostic dataset by applying a window having a set or predefined size to the raw diagnostic dataset and determining a representative value of a plurality of pieces of raw diagnostic data included in the window. In some examples, the processor 200 may generate the smoothed diagnostic dataset by sliding the window stepwise from a first raw diagnostic data to a last raw diagnostic data of the raw diagnostic dataset and sequentially arranging the representative values determined at each sliding operation.

Subsequently, the processor 200 generates a normalized diagnostic dataset by normalizing the raw diagnostic dataset using the smoothed diagnostic dataset (S300). In some embodiments, the processor 200 generates the normalized diagnostic dataset as a difference between the raw diagnostic dataset and the smoothed diagnostic dataset.

Subsequently, the processor 200 diagnoses the plurality of battery cells based on the normalized diagnostic dataset (S400). In some embodiments, the processor may diagnose the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality pieces of pieces of normalized diagnostic data with the determined reference value.

The method of diagnosing the battery according to some embodiments may be written as a computer program for performing the operations described above (e.g., S100 to S400) by being combined with hardware, and be implemented in a general-purpose digital computer that runs the computer program by being stored in a computer-readable recording medium. The computer-readable recording medium may correspond to a hardware device that is specifically configured to store and execute program instructions, such as a read-only memory (ROM), a random access memory (RAM), a hard disk, a floppy disk, magnetic media such as a magnetic tape, optical media such as a compact disc read-only memory (CD-ROM), a digital versatile disc (DVD), magneto-optical media such as a floptical disk, a flash memory, etc.

According to the present disclosure, by acquiring a low voltage dataset of a plurality of battery cells to be diagnosed, generating a smooth voltage dataset by smoothing noise reflected in the raw diagnostic dataset due to the positional deviation in the plurality of battery cells, and generating a normalized diagnostic dataset by normalizing the raw diagnostic dataset through the smoothed diagnostic dataset, and then diagnosing the plurality of battery cells based on the normalized diagnostic dataset, abnormal battery cells having a low voltage can be detected more accurately without being influenced by the deviation in environmental conditions of each cell due to the deviation in positions where cells are left unattended.

However, effects that can be achieved through the present disclosure are not limited to the above-described effects and other effects that are not described may be clearly understood by those skilled in the art from the detailed descriptions.

The embodiments described in this specification can be implemented as, for example, a method or process, a device, a software program, a data stream, and/or a signal. Even when discussed only in the context of a single form of implementation (e.g., discussed only as a method), the implementation of the discussed feature can also be implemented in other forms (e.g., as devices or programs). The device can be implemented with appropriate hardware, software, firmware, etc. The method may be implemented in a device such as a processor, which generally refers to a processing device including, for example, a computer, a microprocessor, an integrated circuit, or a programmable logic device. The processor also includes a communication device such as a computer, a cellular phone, a personal digital assistant (PDA), and other devices that facilitate communication of information between end-users.

Although the present disclosure has been described with reference to embodiments and drawings illustrating aspects thereof, the present disclosure is not limited thereto. Various suitable modifications and variations can be made by a person skilled in the art to which the present disclosure pertains within the scope of the present disclosure as defined by the claims and their equivalents.

## Claims

1. An apparatus for diagnosing a plurality of battery cells based on diagnostic data acquired from the plurality of battery cells, the apparatus comprising:
a processor configured to diagnose the plurality of battery cells; and
a memory configured to store instructions for execution by the processor, wherein, based on the instructions, the processor is configured to:
acquire a raw diagnostic dataset of the plurality of battery cells;
generate a smoothed diagnostic dataset by smoothing noise in the raw diagnostic dataset due to a deviation in positions at which the plurality of battery cells are left unattended;
generate a normalized diagnostic dataset by normalizing the raw diagnostic dataset based on the smoothed diagnostic dataset; and
diagnose the plurality of battery cells based on the normalized diagnostic dataset.

2. The apparatus of claim 1, wherein the processor is configured to acquire the raw diagnostic dataset by arranging the raw diagnostic data of each of the plurality of battery cells based on continuity of the positions at which the plurality of battery cells are left unattended.

3. The apparatus of claim 1 or claim 2, wherein the processor is configured to generate the smoothed diagnostic dataset by applying a window having a set size to the raw diagnostic dataset and determining a representative value of a plurality of pieces of raw diagnostic data within the window.

4. The apparatus of claim 3, wherein the processor is configured to generate the smoothed diagnostic dataset by sliding the window stepwise from first raw diagnostic data to last raw diagnostic data of the raw diagnostic dataset and sequentially arranging representative values determined at each sliding operation.

5. The apparatus of claim 3 or claim 4, wherein the representative value is a median value.

6. The apparatus of any preceding claim, wherein the processor is configured to generate the normalized diagnostic dataset as a difference between the raw diagnostic dataset and the smoothed diagnostic dataset.

7. The apparatus of any preceding claim, wherein the processor is configured to diagnose the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality of pieces of normalized diagnostic data with the determined reference value.

8. The apparatus of any preceding claim, wherein the diagnostic data is a cell voltage change amount or an open circuit voltage change amount of each of the plurality of battery cells formed after the plurality of battery cells are left unattended for a reference time in a formation process of the plurality of battery cells.

9. The apparatus of claim 8, wherein the plurality of battery cells are loaded on a tray in a form of a matrix and left unattended for the reference time to acquire the diagnostic data in the formation process.

10. A method of diagnosing a plurality of battery cells based on diagnostic data acquired from the plurality of battery cells, the method comprising:
acquiring, by a processor, a raw diagnostic dataset of the plurality of battery cells;
generating, by the processor, a smoothed diagnostic dataset by smoothing noise reflected in the raw diagnostic dataset due to a deviation in positions at which the plurality of battery cells are left unattended;
generating, by the processor, a normalized diagnostic dataset by normalizing the raw diagnostic dataset based on the smoothed diagnostic dataset; and
diagnosing, by the processor, the plurality of battery cells based on the normalized diagnostic dataset.

11. The method of claim 10, wherein, in the acquiring of the raw diagnostic dataset, the processor acquires the raw diagnostic dataset by arranging the raw diagnostic data of each of the plurality of battery cells based on continuity of the positions at which the plurality of battery cells are left unattended.

12. The method of claim 10 or claim 11, wherein, in the generating of the smoothed diagnostic dataset, the processor generates the smoothed diagnostic dataset by applying a window having a set size to the raw diagnostic dataset and determining a representative value of a plurality of pieces of raw diagnostic data included in the window.

13. The method of claim 12, wherein, in the generating of the smoothed diagnostic dataset, the processor generates the smoothed diagnostic dataset by sliding the window stepwise from first raw diagnostic data to last raw diagnostic data of the raw diagnostic dataset and sequentially arranging representative values determined at each sliding operation.

14. The method of any of claims 10-13, wherein, in the generating of the normalized diagnostic dataset, the processor generates the normalized diagnostic dataset as a difference between the raw diagnostic dataset and the smoothed diagnostic dataset.

15. The method of any of claims 10-14, wherein, in the diagnosing of the plurality of battery cells, the processor diagnoses the plurality of battery cells by determining a representative value of a plurality of pieces of normalized diagnostic data included in the normalized diagnostic dataset, determining a reference value that serves as a diagnostic reference for the plurality of battery cells according to the determined representative value, and comparing the plurality of pieces of normalized diagnostic data with the determined reference value.
